# EUROPÄISCHE PATENTSCHRIFT

(11) **EP 2 462 790 B1**
(45) Veröffentlichungstag und Bekanntmachung des Hinweises auf die Patenterteilung: **06.09.2017**
(21) Anmeldenummer: 09777673.6
(22) Anmeldetag: 05.08.2009
(51) Int. Cl.: H05K 7/14, G06K 17/00

(54) **AUFNAHMEVORRICHTUNG MIT RFID-ERFASSUNG VON DARIN AUFGENOMMENEN EINBAUKOMPONENTEN, SOWIE RFID-ERFASSUNGSVERFAHREN**
RECEIVING DEVICE WITH RFID DETECTION OF BUILT-IN COMPONENTS HELD THEREIN, AND RFID DETECTION METHOD
DISPOSITIF DE LOGEMENT AVEC DÉTECTION RFID DE COMPOSANTS INCORPORÉS DANS CELUI-CI AINSI QUE PROCÉDÉ DE DÉTECTION RFID

(43) Veröffentlichungstag der Anmeldung: 13.06.2012
(73) Patentinhaber: Kilian, Dieter, 82140 Olching (DE)
(72) Erfinder: Kilian, Dieter, 82140 Olching (DE)
(74) Vertreter: Roos, Peter
(86) Internationale Anmeldenummer: PCT/EP2009/005670
(87) Internationale Veröffentlichungsnummer: WO 2011/015212

(56) Entgegenhaltungen:
- WO-A1-2009/091888
- DE-A1-102007 034 437
- US-A1- 2004 178 270
- US-A1- 2006 171 538
- US-A1- 2008 265 722

## Beschreibung

Die Erfindung betrifft eine Aufnahmevorrichtung, insbesondere Schrank oder Rack, mit einem Aufnahmeraum zur Aufnahme von mit RFID-Transpondern versehenen Einbaukomponenten, und mit einer Erfassungseinrichtung zur Erfassung von aufgenommenen Einbaukomponenten, die mit einer Auswerteeinrichtung verbunden oder verbindbar ist und wenigstens eine RFID-Antenne zur Kommunikation mit den RFID-Transpondern der aufgenommenen Einbaukomponenten aufweist.

Eine derartige Aufnahmevorrichtung ist beispielsweise aus der DE 10 2007 034 437 A1 bekannt und weist einen Aufnahmeraum zur Aufnahme von Einbaukomponenten sowie eine Erfassungseinrichtung zur Erfassung von tatsächlich aufgenommenen Einbaukomponenten auf. Die Erfassung basiert auf so genannter RFID-Technik und erfordert, dass die Einbaukomponenten jeweils mit einem RFID-Transponder versehenen sind.

Die RFID ("radio frequency identification") ist ganz allgemein eine Technik zur drahtlosen Identifikation von Objekten. Ein RFID-System besteht aus zumindest einem Lesegerät mit zumindest einer RFID-Antenne zum Auslesen von Daten aus in Lesereichweite befindlichen RFID-Transpondern. Die Kommunikation bzw. Datenübertragung zwischen RFID-Transponder und Lesegerät erfolgt mittels elektromagnetischer Wellen. Bei niedrigeren Frequenzen geschieht dies induktiv über das elektromagnetische Nahfeld, bei höheren Frequenzen über das elektromagnetische Fernfeld. Das Lesegerät kann wie auch der RFID-Transponder sowohl als Sender als auch als Empfänger von zu übertragenden Daten fungieren.

Die Erfassungseinrichtung der bekannten Aufnahmevorrichtung ist mit einer Auswerteeinrichtung verbunden oder verbindbar und umfasst eine Vielzahl von entlang des Aufnahmeraumes angeordneten RFID-Antennen zur jeweils kurzreichweitigen Kommunikation mit den RFID-Transpondern der aufgenommenen Einbaukomponenten. Damit ist es möglich, verschiedene Einbaukomponenten zu erkennen und ihr Vorhandensein oder Nicht-Vorhandensein zu erfassen ("Inventarisierung"). Durch die Gestaltung der Erfassungseinrichtung mit einer Vielzahl von Einzelantennen mit jeweils relativ kurzer Kommunikationsreichweite kann neben der Erfassung des bloßen Vorhandenseins auch eine Information betreffend die Positionen der innerhalb des Aufnahmeraumes aufgenommenen Einbaukomponenten gewonnen werden.

Problematisch sind bei der aus der DE 10 2007 034 437 A1 bekannten Aufnahmevorrichtung jedoch Fälle, in welchen die genaue Anordnung des RFID-Transponders an den einzelnen Einbaukomponenten nicht exakt vorgegeben ist und/oder Einbaukomponenten mit unterschiedlichen Abmessungen in die Aufnahmevorrichtung eingebaut werden. In solchen Fällen kann nämlich selbst aus einer genauen Kenntnis der Position eines komponenteneigenen RFID-Transponders nicht unbedingt auf die genauen Abmessungen und die genaue Einbauposition der betreffenden Einbaukomponente geschlossen werden.

Aus der WO 2009/091888 A1 ist eine Aufnahmevorrichtung der eingangs genannten Art bekannt, die eine Mehrzahl von entlang des Aufnahmeraumes verteilt angeordneten RFID-Transpondern aufweist, die jeweils abhängig von einem Vorhandensein oder Nicht-Vorhandensein einer Einbaukomponente in der Nähe des jeweiligen RFID-Transponders mit einem RFID-Transponder der Einbaukomponente "gekoppelt" werden.

Bei dem damit realisierten RFID-Erfassungssystem weisen also nicht nur die Einbaukomponenten jeweils einen RFID-Transponder auf, nachfolgend auch als "komponenteneigene RFID-Transponder" bezeichnet, sondern es sind weitere RFID-Transponder als Teil der Aufnahmevorrichtung vorgesehen, die daher nachfolgend auch als "vorrichtungseigene RFID-Transponder" bezeichnet werden.

Die bei der WO 2009/091888 A1 vorgesehene "Kopplung" zwischen einem komponenteneigenen RFID-Transponder und einem vorrichtungseigenen RFID-Transponder wird durch Herstellung einer elektrischen Verbindung zwischen den Schaltkreisen der beiden Transponder bewerkstelligt, woraufhin die beiden Transponder Daten (z. B. deren Identifikationsnummern) austauschen. Dadurch, dass die vorrichtungseigenen Transponder entlang des Aufnahmeraumes verteilt angeordnet sind und deren Kopplungen durch das Vorhandensein oder Nicht-Vorhandensein einer Einbaukomponente in deren Nähe veränderbar sind, kann mittels der Erfassungseinrichtung nicht nur das bloße Vorhandensein oder Nicht-Vorhandensein von Einbaukomponenten im Aufnahmeraum erfasst werden, sondern es ist vorteilhaft auch eine Erfassung der Einbaupositionen innerhalb des Aufnahmeraumes ermöglicht.

Aus der US 2004/01787270 A1 ist ein Verfahren sowie eine Vorrichtung zur Erfassung von mit RFID-Transpondern versehenen und in einer Aufnahmevorrichtung aufgenommenen Einbaukomponenten bekannt. Die Erfassung eines Vorhandenseins und der Einbaupositionen der Einbaukomponenten beruht hierbei auf einer kurzreichweitigen Datenübertragung von Daten der RFID-Transponder mittels in der Aufnahmevorrichtung verteilt angeordneter Leseeinrichtungen (mit "kurzer Lesereichweite").

Es ist eine Aufgabe der vorliegenden Erfindung, einen alternativen Weg aufzuzeigen, um bei einer Aufnahmevorrichtung der eingangs genannten Art die Positionsbestimmung der im Aufnahmeraum befindlichen Einbaukomponenten zu verbessern.

Diese Aufgabe wird gemäß der Erfindung durch eine Aufnahmevorrichtung nach Anspruch 1 gelöst. Die abhängigen Ansprüche betreffen vorteilhafte Weiterbildungen der Erfindung.

Bei der erfindungsgemäßen Aufnahmevorrichtung kann es sich insbesondere um einen Schrank oder ein Rack handeln, beispielsweise einen Elektroschrank bzw. Schaltschrank zur Aufnahme von elektrischen oder elektronischen Einbaugeräten, oder ein so genanntes "IT-Rack" (z. B. "Server-Rack") zur Aufnahme von elektrischen oder elektronischen Einbaugeräten der Informationstechnologie (IT).

Der Begriff "Rack" soll hier eine Haltevorrichtung bezeichnen, mittels welcher eine Mehrzahl kleinerer Einbaukomponenten zu einer baulichen Einheit ("bestücktes Rack") zusammengefasst werden können. In diesem Sinne kann es sich bei einem Rack z. B. um einen Ständer oder ein Gestell handeln, welches für eine positionierte Aufnahme und Halterung von hierfür vorgesehenen Einbaukomponenten geeignet ausgebildet ist.

Der Begriff "Schrank" soll demgegenüber eine Haltevorrichtung bezeichnen, die wie ein Rack zur Aufnahme von Einbaukomponenten vorgesehen ist, jedoch im Unterschied zum Rack außerdem flächige Wandungen aufweist, mit welchen ein Innenraum der Vorrichtung zumindest größtenteils umschlossen ist (z. B. durch Schrankseitenwände) oder umschließbar ist (z. B. durch Schranktüren etc.).

In einer bevorzugten Ausführungsform ist vorgesehen, dass mögliche Einbaupositionen der Einbaukomponenten im Aufnahmeraum durch ein "Einbauraster" der Aufnahmevorrichtung vorgegeben sind, insbesondere durch ein Einbauraster, welches durch die Positionen einer entlang eines langgestreckten, z. B. vertikal verlaufenden Einbaurahmenteils ausgebildete Reihe von Befestigungsmitteln definiert ist.

Der Begriff "Raster" soll hier allgemein eine regelmäßige Anordnung von Rasterpunkten entlang einer Fläche (Flächenraster) oder entlang einer Linie (Linienraster) bezeichnen. Bei einem Linienraster liegt eine Regelmäßigkeit der Anordnung insbesondere dann vor, wenn die Rasterpunkte äquidistant entlang der Linie angeordnet sind. Als regelmäßige Anordnung soll hier jedoch auch eine Anordnung von Rasterpunkten bezeichnet werden, bei welcher sich ganz allgemein ein Anordnungsmuster mit einer bestimmten Periodizität wiederholt. Hierfür müssen die einzelnen, z. B. auf einer Linie liegenden Rasterpunkte nicht unbedingt äquidistant zueinander sein. Vielmehr genügt eine periodische Wiederholung von bestimmten gegenseitigen Abständen der Rasterpunkte.

In einer bevorzugten Ausführungsform sind die möglichen Einbaupositionen innerhalb des Aufnahmeraumes durch ein sich linienförmig vertikal erstreckendes Einbauraster vorgegeben, welches durch die Positionen einer entlang eines vertikalen langgestreckten Einbaurahmenteils ausgebildete Reihe von Befestigungsmitteln, z. B. Montagelöchern, definiert ist. Bei einem Einbauraster, welches durch die Positionen (Rasterpunkte) von Befestigungsmitteln, z. B. Montagelöchern, definiert ist, kann zum Einbau einer Komponente diese mittels wenigstens eines solchen Befestigungsmittels in der gewünschten Einbauposition fixiert (z. B. verschraubt) werden.

In einer bevorzugten Ausführungsform ist vorgesehen, dass die vorrichtungseigenen RFID-Transponder auf einem entlang des Aufnahmeraumes verlaufenden Transponderraster angeordnet sind, insbesondere einem Transponderraster, welches korrespondierend zu einem Einbauraster der Aufnahmevorrichtung ausgebildet ist.

Die "korrespondierende" Ausbildung des Transponderrasters zum Einbauraster soll z. B. den Fall umfassen, dass die beiden Raster identisch oder im Wesentlichen identisch (z. B. nur geringfügig in Rasterrichtung zueinander verschoben) sind. Darüber hinaus soll eine korrespondierende Ausbildung auch dann vorliegen, wenn eine Periode bzw. Periodenlänge des einen Rasters auch eine Periode bzw. Periodenlänge des anderen Rasters darstellt.

Bevorzugt ist ein Transponderraster vorgesehen, welches für alle denkbaren Bestükkungssituationen der Aufnahmevorrichtung jeweils zur exakten Erfassung der Einbaupositionen der einzelnen Einbaukomponenten geeignet ist.

In einer Ausführungsform ist vorgesehen, dass die wenigstens eine zur Kommunikation mit den komponenteneigenen RFID-Transpondern ohnehin vorgesehene RFID-Antenne auch zur Kommunikation mit den vorrichtungseigenen RFID-Transpondern nutzbar ist.

Alternativ oder zusätzlich kann jedoch auch vorgesehen sein, dass die Erfassungseinrichtung zur Kommunikation mit den vorrichtungseigenen RFID-Transpondern wenigstens eine weitere RFID-Antenne aufweist. Dies bedeutet zwar einen gewissen Mehraufwand, der jedoch in manchen Fällen im Hinblick auf die Erfassungszuverlässigkeit gerechtfertigt sein kann.

Bei der Erfindung ist eine "Veränderbarkeit der Transponderwirkung" der vorrichtungseigenen RFID-Transponder in Abhängigkeit von einem Vorhandensein oder Nicht-Vorhandensein einer Einbaukomponente in Transpondernähe vorgesehen, die in vielfältiger Weise realisiert sein kann. Die entsprechenden technischen Realisierungsvarianten können z. B. danach klassifiziert werden, ob diese Veränderung bei Einbau oder Ausbau einer Einbaukomponente automatisch bzw. zwangsläufig erfolgt, oder ob hierfür irgendeine Handlung eines Benutzers erforderlich ist (welcher den Einbau bzw. Ausbau durchführt). Beide Varianten sind im Rahmen der Erfindung möglich.

Unter "Veränderung der Transponderwirkung" ist im weitesten Sinne jede solche Veränderung zu verstehen, welche sich durch eine Auswertung der Kommunikation zwischen dem betreffenden RFID-Transponder und der für diese Kommunikation vorgesehenen Antenne detektieren lässt.

Bei der Erfindung basiert diese Detektion auf der Qualität der Kommunikation, oder gleichbedeutend auf der Qualität der Kommunikationsstrecke zwischen Transponder und Antenne. Hierfür kann als besonders einfache Realisierungsvariante vorgesehen sein, dass je nach Vorhandensein oder Nicht-Vorhandensein einer Einbaukomponente in der Nähe des Transponders eine solche Kommunikation im einen Fall funktechnisch nennenswert verschlechtert bzw. ganz unterbunden ist, wohingegen im anderen Fall eine solche Kommunikation (funktechnisch) ermöglicht bzw. nennenswert verbessert ist.

Hierfür kann z. B. vorgesehen sein, dass bei Vorhandensein der Einbaukomponente die Kommunikation verschlechtert bzw. unterbunden ist und bei Nicht-Vorhandensein der Einbaukomponente verbessert bzw. erst ermöglicht ist. Ebenso gut kann jedoch auch eine umgekehrte Zuordnung zwischen der Belegungssituation in der Nähe des Transponders einerseits und der Kommunikationsqualität andererseits vorgesehen sein.

Die vorstehend erläuterte Veränderung der Kommunikationsqualität durch den Einbau oder Ausbau einer Einbaukomponente kann z. B. durch eine entsprechende Lageveränderung eines elektrisch leitfähigen Bereiches (mit Abschirmwirkung) und/oder eine Abstandsveränderung zwischen Transponder und Antenne und/oder eine Orientierungsveränderung des Transponders bezüglich der Antenne realisiert sein.

Der erwähnte elektrisch leitfähige Bereich kann als Teil (z. B. metallischer Gehäusebereich) der betreffenden Einbaukomponente oder als ein eigens zum Zwecke der belegungsabhängigen Abschirmung vorgesehenes Teil (z. B. metallisches Abschirmblech) vorgesehen sein. Ein solches Abschirmteil kann z. B. ein entsprechend ausgebildetes Bauteil der Aufnahmevorrichtung darstellen.

Die erwähnte Abstandsveränderung zwischen Transponder und Antenne kann z. B. durch eine Translation und/oder eine Verschwenkung des Transponders realisiert sein. Alternativ oder zusätzlich kann eine solche Translation und/oder Verschwenkung auch bewirken, dass der Transponder dadurch in einen abgeschirmten räumlichen Bereich hinein bzw. heraus bewegt wird.

Die erwähnte Orientierungsveränderung des Transponders bezüglich der Antenne kann z. B. durch eine Verschwenkung oder Verdrehung des Transponders (bei z. B. stationärer Antenne) bewerkstelligt sein.

Gemäß einer anderen Ausführungsform kann die vorstehend erläuterte Veränderung der Kommunikationsqualität durch den Einbau bzw. Ausbau einer Einbaukomponente durch eine elektrische Kontaktierung wenigstens eines Abschnittes einer Antenne des betreffenden RFID-Transponders realisiert sein, um die Wirkung dieser Antenne und somit die Transponderwirkung detektierbar zu verändern. Beispielsweise können hierfür Beeinflussungsmittel vorgesehen sein, welche die Endbereiche einer dipolartig gestalteten Antenne elektrisch kurzschließen. Allgemein können derartige Antennenabschnitte beim Einbau von Einbaukomponenten galvanisch leitend berührt bzw. ganz oder teilweise durch ein abschirmendes Teil überdeckt werden.

Da die Wirkung einer Antenne im Allgemeinen maßgeblich von den Eigenschaften der Umgebung der Antenne abhängt, kann gemäß einer weiteren Ausführungsform eine Beeinflussung der Antennenwirkung und somit Transponderwirkung auch durch gezieltes Verlagern eines "von Luft verschiedenen" Teils im Funkweg zwischen RFID-Antenne und RFID-Transponder erfolgen. Beispielsweise kann dies durch Annähern bzw. Entfernen eines z. B. elektrisch leitfähigen Teils an bzw. von der Antenne des Transponders erfolgen. Damit kann z. B. eine Veränderung der (Antennen-) Resonanzfrequenz bzw. Verstimmung der Antenne bewirkt werden. Bei einem derartigen Beeinflussungsprinzip könnte man auch von einer funktechnischen Abschirmung (bzw. Freigabe einer Abschirmung) im weitesten Sinne sprechen. Hinsichtlich der Gestaltung und Anordnung hierfür geeigneter elektrisch leitfähiger Bereiche (alternativ: z. B. Bereiche mit speziellen (von Luft verschiedenen) dielektrischen Eigenschaften) ist auf die hier zum Beeinflussungsprinzip der "Abschirmung" gegebenen Erläuterungen zu verweisen.

In einer Ausführungsform ist vorgesehen, dass die Veränderung der Transponderwirkung der vorrichtungseigenen RFID-Transponder zwangsläufig durch den Einbau oder Ausbau einer Einbaukomponente in der Nähe des jeweiligen vorrichtungseigenen RFID-Transponders bewirkt wird.

In einer diesbezüglichen Weiterbildung ist vorgesehen, dass die Qualität der Kommunikationsstrecke zwischen dem jeweiligen vorrichtungseigenen RFID-Transponder und einer für die Kommunikation mit diesem RFID-Transponder vorgesehenen Antenne zwangsläufig durch das Vorhandensein bzw. Nicht-Vorhandensein elektrisch leitfähiger Bereiche der Einbaukomponente verändert wird. Hierbei wird gewissermaßen ein "elektromagnetischer Wirkmechanismus" für die Kommunikationsveränderung genutzt, welcher auf dem Abschirmeffekt von elektrisch leitfähigen Bereichen für die RFID-Kommunikation basiert. Alternativ oder zusätzlich kann hierbei vorgesehen sein, dass durch das Vorhandensein bzw. Nicht-Vorhandensein elektrisch leitfähiger Bereiche im Wesentlichen bereits die Antennenwirkung des betreffenden Transponders verändert wird.

Alternativ oder zusätzlich kann vorgesehen sein, dass die Qualität der Kommunikationsstrecke zwischen dem jeweiligen vorrichtungseigenen RFID-Transponder und einer für die Kommunikation mit diesem RFID-Transponder vorgesehenen Antenne durch eine manuell bewirkte oder zwangsgesteuerte Lageveränderung des jeweiligen vorrichtungseigenen RFID-Transponders verändert wird.

Auch im Falle einer Lageveränderung des jeweiligen RFID-Transponders wird ein "elektromagnetischer Wirkmechanismus" ausgenutzt, der z. B. auf einer Veränderung einer Abschirmwirkung beruht (falls der Transponder zwischen funktechnisch "unterschiedlich ausgeleuchteten" räumlichen Bereichen bewegt wird), und/oder auf einer Veränderung der Signalstärke der RFID-Kommunikation beruht, die bereits durch die physikalisch-prinzipielle Abhängigkeit der Signalstärke vom Abstand zwischen Transponder und Antenne bedingt ist, und/oder auf einer Veränderung der Signalstärke durch einen Richteffekt und/oder Polarisationseffekt beruht (falls Antenne und/oder Transponder richtungsabhängige bzw. polarisationsabhängige Sende- und/oder Empfangseigenschaften hinsichtlich der elektromagnetischen RFID-Strahlung besitzen).

In einer Ausführungsform sind durch einen Benutzer manuell bedienbare Mittel zur Bewirkung der Veränderung der Transponderwirkung vorgesehen. Hierfür kommen z. B. vom Benutzer vor, während oder nach einem Einbau oder Ausbau einer Einbaukomponente manuell betätigbare Taster, Schieber, Klappen, Drehknöpfe oder dergleichen als "Bedieneinrichtungen" in Betracht, durch deren manuelle Betätigung die Veränderung der Transponderwirkung bewirkt wird. Jede solche Bedieneinrichtung kann z. B. direkt oder indirekt über eine mechanische Wirkverbindung (Getriebe, Gestänge oder dergleichen), mit einem zugeordneten Transponder verbunden sein, um diesen bei der manuellen Bedienung gezielt zu verlagern. Alternativ oder zusätzlich zu einer Verlagerung des zugeordneten Transponders kann hierbei auch eine Verlagerung eines anderen zugeordneten Teils, z. B. eines Abschirmbleches, vorgesehen sein.

Beispielsweise kann vorgesehen sein, dass durch eine solche manuelle Bedienung eine Veränderung der Qualität der Kommunikation bzw. Qualität der Kommunikationsstrecke zwischen Antenne und Transponder hervorgerufen wird, wie dies oben bereits erläutert wurde.

Beispielsweise kann für jeden vorrichtungseigenen RFID-Transponder ein elektrisch leitfähiges Abschirmteil (z. B. Abschirmblech aus Metall) durch den Benutzer direkt oder indirekt derart bewegbar sein, dass damit die Kommunikationsqualität wie oben bereits beschrieben verändert wird. Das Abschirmteil kann z. B. verschoben und/oder verschwenkt und/oder verdreht werden. Diese Bedienhandlung ist dann vom Benutzer auszuführen, wenn dieser eine Einbaukomponente einbaut oder ausbaut.

Ebenfalls z. B. wie oben bereits für automatisch bzw. zwangsläufig erfolgende Veränderungen der Transponderwirkung können auch für die manuelle Veränderung der Transponderwirkung verschiedene Wirkmechanismen, einzeln oder kombiniert, vorgesehen sein, wie etwa Wirkmechanismen beruhend auf einer Abstandsveränderung und/oder Orientierungsveränderung zwischen Transponder und Antenne.

Der Benutzer kann bei einer solchen Bedienung ein Abschirmteil oder den Transponder bzw. ein den Transponder tragendes Teil z. B. direkt anfassen und in seiner Lage verändern (z. B. verschieben und/oder verschwenken). Alternativ kann z. B. eine nur indirekte Lageveränderung vorgesehen sein, die mittels eines Mechanismus erfolgt, der funktional zwischen einem Bedienelement und dem lagezuverändernden Teil (z. B. Transponder oder Abschirmteil) angeordnet ist.

Gemäß eines weiteren Aspekts der vorliegenden Erfindung ist ein RFID-Erfassungsverfahren vorgesehen, welches mittels einer Aufnahmevorrichtung der oben beschriebenen Art durchgeführt wird. Ein solches RFID-Erfassungsverfahren ermöglicht eine automatische Inventarisierung der aufgenommenen Einbaukomponenten.

Gemäß einer bevorzugten Weiterbildung ist vorgesehen, dass im Bereich der Auswerteeinrichtung oder einer damit verbundenen Datenverarbeitungseinrichtung eine aktuelle Information über die Belegung der Aufnahmevorrichtung mit Einbaukomponenten gespeichert und mittels der RFID-Erfassung automatisch aktualisiert wird.

Wenn die Aufnahmevorrichtung zu einem bestimmten Zeitpunkt eine bestimmte Belegung mit Einbaukomponenten besitzt, die in elektronischer Form gespeichert ist, so entspricht diese Situation einer bestimmten "RFID-Empfangssituation", d. h. es werden Identifikationen von den RFID-Transpondern der aufgenommenen Einbaukomponenten erkannt und darüber hinaus Identifikationen von vorrichtungseigenen RFID-Transpondern entsprechend den belegten (oder unbelegten) Abschnitten des Aufnahmeraumes erkannt. Würde nun ausgehend von dieser Situation eine Einbaukomponente ausgebaut, so kann zum einen erkannt werden, um welche Komponente es sich handelt, weil mit dem Entfernen der Einbaukomponente die entsprechende Identifikation des komponenteneigenen RFID-Transponders dann nicht mehr erfasst wird. Zum anderen kann jedoch auch exakt ermittelt werden, welcher Abschnitt des Aufnahmeraumes durch diesen Ausbau frei wird, und zwar auf zweierlei Weisen, die z. B. parallel verwirklicht sein können: Zum einen ergibt sich die Information über den frei werdenden Abschnitt des Aufnahmeraumes bereits aus dem gespeicherten Belegungsplan, welcher für jede Einbaukomponente den davon beanspruchten Aufnahmeraumabschnitt angibt. Zum anderen kann der frei werdende Aufnahmeraumabschnitt jedoch auch anhand der Veränderung der Transponderwirkung von einem oder mehreren vorrichtungseigenen RFID-Transpondern ermittelt werden, die mit dem Ausbau der Einbaukomponente verbunden ist. Im umgekehrten Fall, wenn eine zusätzliche Einbaukomponente eingebaut würde, so kann zum einen anhand der Erfassung der Identifikation des damit neu hinzukommenden komponenteneigenen RFID-Transponders ermittelt werden, um welche Einbaukomponente es sich handelt. Deren Einbauposition bzw. der von dieser Komponente beanspruchte Aufnahmeraumabschnitt kann wieder anhand der Veränderung der Transponderwirkung von einem oder mehreren vorrichtungseigenen RFID-Transpondern ermittelt werden. Somit kann anhand der RFID-Erfassung der gespeicherte Belegungsplan stets überwacht und aktualisiert werden. Bevorzugt erfolgt dies in programmgesteuerter Weise, z. B. in einer Datenverarbeitungseinrichtung, die hierfür mit der Auswerteeinrichtung verbunden ist (oder deren Funktion übernimmt) und auf welcher eine entsprechende "Inventarisierungssoftware" läuft.

Die Erfindung wird nachfolgend anhand von Ausführungsbeispielen mit Bezug auf die beigefügten Zeichnungen weiter beschrieben. Es stellen dar:
- Fig. 1: eine perspektivische Ansicht einer Aufnahmevorrichtung (Schaltschrank) gemäß eines ersten Ausführungsbeispiels,
- Fig. 2: ein Detail aus Fig. 1,
- Fig. 3: eine schematische Vorderansicht sowie eine schematische Draufsicht eines Details der Aufnahmevorrichtung von Fig. 1,
- Fig. 4: eine schematische Darstellung eines Details von Fig. 3 in einer Abwandlung,
- Fig. 5: eine schematische Darstellung eines Details von Fig. 3 in einer Abwandlung,
- Fig. 6: eine perspektivische Teilansicht wesentlicher Komponenten einer Aufnahmevorrichtung (IT-Rack) gemäß eines zweiten Ausführungsbeispiels,
- Fig. 7: ein Detail aus Fig. 6,
- Fig. 8: eine Ansicht ähnlich Fig. 6, jedoch mit Darstellung einer darin positionierten Einbaukomponente,
- Fig. 9: ein Detail aus Fig. 8,
- Fig. 10: eine schematische Draufsicht einer positionierten Einbaukomponente,
- Fig. 11: ein Detail aus Fig. 10,
- Fig. 12: eine der Fig. 11 entsprechende Ansicht gemäß eines abgewandelten, weiteren Ausführungsbeispiels,
- Fig. 13: eine der Fig. 11 entsprechende Darstellung eines noch weiteren Ausführungsbeispiels,
- Fig. 14: eine der Fig. 11 entsprechende Darstellung eines noch weiteren Ausführungsbeispiels,
- Fig. 15: eine der Fig. 11 entsprechende Darstellung eines noch weiteren Ausführungsbeispiels,
- Fig. 16: eine der Fig. 11 entsprechende Darstellung eines noch weiteren Ausführungsbeispiels,
- Fig. 17: eine der Fig. 11 entsprechende Darstellung eines noch weiteren Ausführungsbeispiels,
- Fig. 18: eine der Fig. 11 entsprechende Darstellung eines noch weiteren Ausführungsbeispiels,
- Fig. 19: eine der Fig. 11 entsprechende Darstellung eines noch weiteren Ausführungsbeispiels,
- Fig. 20: eine den Fig. 4 und 5 entsprechende Darstellung verschiedener Transponderanordnungen,
- Fig. 21: eine der Fig. 11 entsprechende Darstellung eines noch weiteren Ausführungsbeispiels, und
- Fig. 22: eine der Fig. 11 entsprechende Darstellung eines noch weiteren Ausführungsbeispiels.

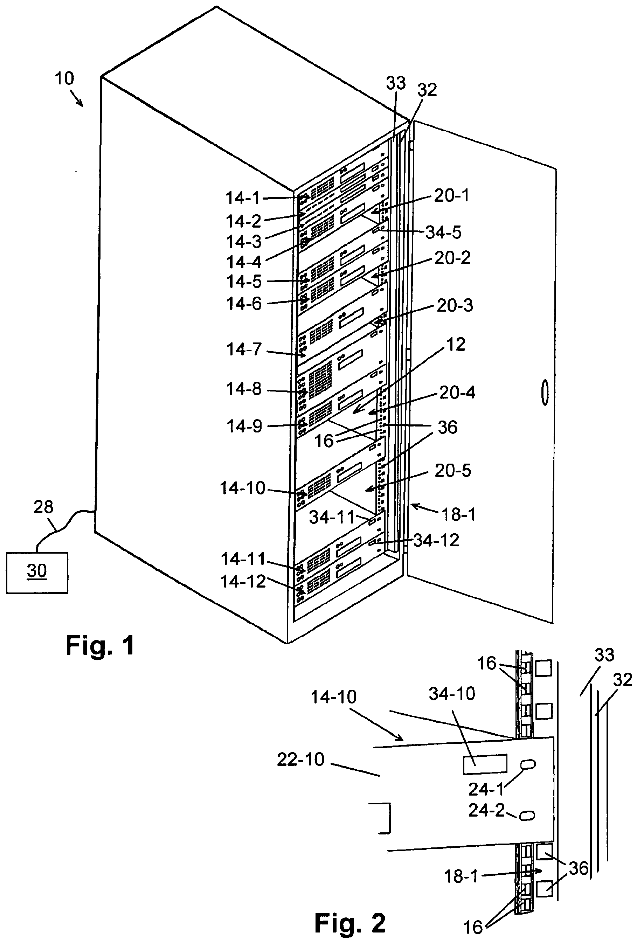

Fig. 1 zeigt eine Aufnahmevorrichtung 10, die als so genannter Elektroschrank oder Schaltschrank mit einem Aufnahmeraum 12 zur Aufnahme von mit RFID-Transpondern 34 versehenen Einbaukomponenten 14 ausgebildet ist.

Die Bezugszahlen von in einer Ausführungsform mehrfach vorgesehenen, in ihrer Wirkung jedoch analogen Komponenten, wie beispielsweise die "Einbaukomponenten 14" oder die "RFID-Transponder 34", sind zumeist durchnumeriert (jeweils ergänzt durch einen Bindestrich und eine fortlaufende Zahl). Auf einzelne solcher Komponenten oder auf die Gesamtheit solcher Komponenten wird in diesem Text auch durch die nicht-ergänzte Bezugszahl Bezug genommen.

Bei den Einbaukomponenten 14 handelt es sich im dargestellten Beispiel um elektrische und/oder elektronische Einrichtungen bzw. Einbaugeräte, deren Abmessungen an die Gestaltung der Vorrichtung 10 bzw. dessen Aufnahmeraum 12 angepasst sind. In dieser Hinsicht kann es sich bei der Vorrichtung 10 z. B. um einen nach einem bestimmten Standard ausgeführten Schaltschrank handeln, wie z. B. einen so genannten "19-Zoll-Schaltschrank", beispielsweise zur Aufnahme von Einbaugeräten (z. B. Servern) der Informationstechnologie (IT).

Mögliche Einbaupositionen der Einbaukomponenten 14 im Aufnahmeraum 12 sind in an sich bekannter Weise durch ein Einbauraster vorgegeben, welches durch die Positionen von Befestigungslöchern 16 definiert ist, welche entlang von langgestreckten, vertikal verlaufenden Einbaurahmenteilen 18-1 bis 18-4 ("Lochleisten") ausgebildet sind.

In den Fig. 1 und 2 ist lediglich eines dieser Einbaurahmenteile 18, nämlich ein rechtes vorderes Einbaurahmenteil 18-1 zu erkennen. Zusammen mit den sich vertikal parallel dazu erstreckenden anderen Einbaurahmenteilen 18-2 bis 18-4 (vorne links, hinten rechts, hinten links) wird der im Wesentlichen quaderförmige Aufnahmeraum 12 zur Unterbringung der Einbaukomponenten 14 ausgebildet.

In der dargestellten Situation ist die Aufnahmevorrichtung 10 mit insgesamt 12 Einbaukomponenten 14-1 bis 14-12 bestückt, von welchen die Komponenten 14-2 und 14-3 eine relativ geringe Bauhöhe von einer so genannten "Höheneinheit" (HE) besitzen, die Komponenten 14-7 und 14-8 eine relativ große Bauhöhe von 3 HE bzw. 4 HE und die übrigen Komponenten eine Bauhöhe von 2 HE besitzen.

Die genaue Höhenpositionierung jeder Komponente 14 im Aufnahmeraum 12 kann im dargestellten Beispiel auf 1/3 HE genau festgelegt werden. Das durch die vertikale Reihe von Befestigungslöchern 16 definierte Einbauraster ist hierfür entsprechend ausgebildet (mittlerer Lochabstand = 1/3 HE).

In der dargestellten Situation ergeben sich freie Aufnahmeraumabschnitte 20-1 bis 20-5, welche noch Platz für die Unterbringung weiterer Einbaukomponenten bieten bzw. in der Praxis bei Nichtgebrauch üblicherweise mit Abdeckblenden (nicht dargestellt) nach vorne hin abgeschlossen werden. Derartige Abdeckblenden können ebenfalls "Einbaukomponenten" im Sinne der Erfindung darstellen, d. h. jeweils mit einem identifizierenden RFID-Transponder versehen sein. Der Einbau von solchen Abdeckblenden ist in vielen Anwendungsfällen, z. B. wenn der Aufnahmeraum klimatisiert (aktiv gekühlt) wird, von großem Vorteil bzw. sogar erforderlich. Insofern ist auch die Miterfassung der Abdeckblenden bei der Ermittlung der aktuellen Belegungssituation der Aufnahmevorrichtung oftmals von Vorteil. Wie bei den Einbaukomponenten 14 selbst kann auch bei den freien Aufnahmeraumabschnitten 20 deren Höhe variieren (in Schritten von 1/3 HE).

Wie es in Fig. 2 am Beispiel der Einbaukomponente 14-10 veranschaulicht ist, erfolgt die Befestigung der Einbaukomponenten 14 jeweils mittels einer Verschraubung einer Frontplatte 22 der betreffenden Einbaukomponente an den vorderen Einbaurahmenteilen 18-1 und 18-2. Jede Frontplatte 22 besitzt hierfür an beiden seitlichen Enden jeweils wenigstens ein Befestigungsloch 24, welches beim Einbau fluchtend mit einem der Befestigungslöcher 16 angeordnet werden kann, um die Einbaukomponente durch eine Verschraubung zu fixieren. Im dargestellten Beispiel von Fig. 2 besitzt die Frontplatte 22-10 der Einbaukomponente 14-10 insgesamt vier Befestigungslöcher (2 links, 2 rechts), von denen die beiden rechten ersichtlich sind und mit 24-1 und 24-2 bezeichnet sind.

Eine Besonderheit der Aufnahmevorrichtung 10 besteht darin, dass diese mit einer Erfassungseinrichtung zur Erfassung von momentan aufgenommenen Einbaukomponenten 14 versehen ist. Die Erfassungseinrichtung ist über eine Verkabelung 28 mit einer in diesem Beispiel extern angeordneten Auswerteeinrichtung 30 verbunden, um eine automatische "Inventarisierung" des Inhaltes der Aufnahmevorrichtung 10 zu ermöglichen. Die Verkabelung 28 kann z. B. über eine an der Außenseite der Vorrichtung 10 angeordnete Steckverbindung realisiert sein. Alternativ kommt auch eine drahtlose Datenübertragungsverbindung zwischen der Vorrichtung 10 und der Auswerteeinrichtung 30 (bzw. einer Datenverarbeitungseinrichtung) in Betracht.

Die Erfassung des Schaltschrankinventars erfolgt mittels RFID. Die Erfassungseinrichtung weist hierfür wenigstens eine RFID-Antenne zur Kommunikation mit RFID-Transpondern 34 auf, mit welchen die einzelnen Einbaukomponenten 14 jeweils versehen sind. Im dargestellten Ausführungsbeispiel ist eine in Vertikalrichtung längsverlaufende RFID-Antenne 32 (z. B. "Streifenleitungsantenne") vorgesehen, die an der Vorderseite des Einbaurahmenteils 18-1, auf einer Abstandsleiste (Dielektrikum) 33, aufgesetzt (z. B. verklebt) ist. Alternativ könnte die Antenne 32 an anderer Stelle im oder in der Nähe des Aufnahmeraumes angeordnet sein, z. B. an der Innenseite der Schranktür (vgl. Fig. 1). Die Erfassungseinrichtung besteht im dargestellten Beispiel aus der Antenne 32 und einer damit verbundenen und zur Verkabelung 28 führenden Antennenleitung. Alternativ könnte z. B. noch ein Antennenverstärker in der Vorrichtung 10 aufgenommen sein.

Fig. 2 veranschaulicht ferner die Anordnung des RFID-Transponders 34-10 an der Vorderseite der Frontplatte 22-10 der Einbaukomponente 14-10. Auch die übrigen Einbaukomponenten 14 sind jeweils mit einem solchen komponenteneigenen RFID-Transponder 34 versehen, der im dargestellten Beispiel jeweils vorne auf die Frontplatte 22 aufgeklebt ist.

Die Verwendung von komponenteneigenen RFID-Transpondern 34 und die Anordnung der RFID-Antenne 32 zur Kommunikation mit diesen Transpondern ermöglicht bereits eine "grobe Inventarisierung" dergestalt, dass im Bereich der Auswerteeinrichtung 30 eine Information über die Anzahl und jeweilige Art von momentan im Aufnahmeraum 12 aufgenommenen Einbaukomponenten 14 erhalten werden kann. Jeder komponenteneigene RFID-Transponder 34 speichert hierfür in an sich bekannter Weise entsprechende Daten über die betreffende Einbaukomponente 14.

Darüber hinaus ermöglicht die in die Vorrichtung 10 integrierte RFID-Erfassung im dargestellten Beispiel jedoch auch die Gewinnung einer Information über die jeweiligen Einbaupositionen der Einbaukomponenten 14 im Aufnahmeraum 12. Somit ist eine "genauere Inventarisierung" dergestalt möglich, dass im Bereich der Auswerteeinrichtung 30 (und einer gegebenenfalls damit verbundenen Datenverarbeitungseinrichtung) die Information über einen mehr oder weniger genauen "Belegungsplan" der Aufnahmevorrichtung 10 vorliegt, aus welchem z. B. vorteilhaft auch hervorgehen kann, an welchen Stellen genau die noch freien Aufnahmeraumabschnitte 20 vorhanden sind und welche Höhe diese jeweils besitzen. Basierend auf solchen Informationen kann z. B. festgestellt werden, ob für einen Einbau einer bestimmten Einbaukomponente einer vorgegebenen Bauhöhe überhaupt noch genügend "Höheneinheiten" im Aufnahmeraum 12 frei sind und falls dies der Fall ist, ob der Einbau ohne weiteres möglich ist (ohne bereits eingebaute Komponenten hinsichtlich ihrer Einbaupositionen umzubauen).

Um eine solche genauere Inventarisierung zu ermöglichen, weist die Aufnahmevorrichtung 10 eine Mehrzahl von entlang des Aufnahmeraumes 12 verteilt angeordneten weiteren (vorrichtungseigenen) RFID-Transpondern 36 auf, deren Transponderwirkung in Abhängigkeit von einem Vorhandensein oder Nicht-Vorhandensein einer Einbaukomponente in der unmittelbaren Nähe des jeweiligen RFID-Transponders 36 veränderbar ist.

Im dargestellten Ausführungsbeispiel sind diese vorrichtungseigenen RFID-Transponder 36 an der Vorderseite des Einbaurahmenteils 18-1 derart angeordnet, dass bei jedem Einbau einer Einbaukomponente 14 ein oder mehrere dieser RFID-Transponder 36 durch die Frontplatte 22 der betreffenden Einbaukomponente 14 zwangsläufig abgedeckt und somit elektromagnetisch abgeschirmt werden. Eine für die Kommunikation mit diesen Transpondern 36 vorgesehene RFID-Antenne, im dargestellten Ausführungsbeispiel die RFID-Antenne 32, kann die elektromagnetisch abgeschirmten Transponder sodann nicht mehr erfassen. Gleichzeitig kann jedoch der Einbau der betreffenden Einbaukomponente 14 anhand des daran anhaftenden, komponenteneigenen RFID-Transponders 34 erfasst werden. Durch Auswertung der RFID-Erfassungsergebnisse kann somit in einfacher Weise festgestellt werden, welche Art bzw. welche Einbaukomponente 14 in welcher Position innerhalb des Aufnahmeraumes 12 eingebaut wurde.

Im vorliegenden Beispiel sind die vorrichtungseigenen RFID-Transponder 36 auf einem entlang des Aufnahmeraumes 12 verlaufenden "Transponderraster" angeordnet, welches korrespondierend zu dem Einbauraster der Aufnahmevorrichtung 10 ausgebildet ist. Das Einbauraster ist definiert durch die vertikale Anordnung der Befestigungslöcher 16, deren mittlerer gegenseitiger Abstand 1/3 HE beträgt. Das Transponderraster besteht aus einer korrespondierenden vertikalen Reihe von Transponderpositionen, deren mittlerer gegenseitiger Abstand 2/3 HE beträgt. Die einzelnen vorrichtungseigenen Transponder 36 sind im dargestellten Beispiel jeweils benachbart von einem der Befestigungslöcher 16 angeordnet, wobei jedoch nur benachbart jedes zweiten Befestigungsloches 16 auch ein vorrichtungseigener Transponder 36 angeordnet ist.

Wenngleich bei der Aufnahmevorrichtung 10 die zur Kommunikation mit den komponenteneigenen RFID-Transpondern 34 vorgesehene RFID-Antenne 32 auch zur Kommunikation mit den vorrichtungseigenen RFID-Transpondern 36 genutzt wird, so könnte abweichend davon zur Kommunikation mit den vorrichtungseigenen RFID-Transpondern auch wenigstens eine weitere RFID-Antenne vorgesehen sein. Die zweckmäßigste Anordnung einer oder mehrerer RFID-Antennen hängt z. B. davon ab, an welchen Stellen der Einbaukomponenten die komponenteneigenen RFID-Transponder angeordnet sind. Insbesondere wenn hinsichtlich der Anordnung der komponenteneigenen RFID-Transponder keine Vorgaben bestehen, so ist eine Anordnung mehrerer RFID-Antennen (z. B. in jeder Schrankecke und/oder an mehreren Schrankseiten) von Vorteil, mittels welcher sämtliche komponenteneigenen RFID-Transponder unabhängig von ihrer konkreten Anordnung stets zuverlässig erfasst werden können.

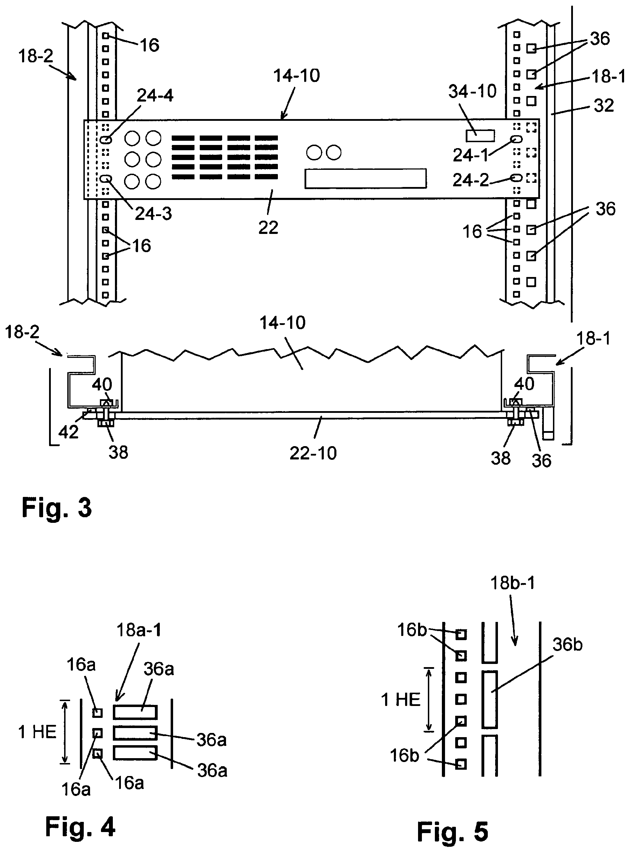

Fig. 3 veranschaulicht nochmals in schematischen Ansichten von vorne und von oben die bereits teilweise in Fig. 2 ersichtliche Einbausituation am Beispiel der Einbaukomponente 14-10.

Aus dem oberen Teil der Figur ist nochmals der vertikale Verlauf des Einbaurasters dargestellt, welches von den als Lochleistenprofile ausgebildeten Einbaurahmenteilen 18-1 und 18-2 mit den Befestigungslöchern 16 definiert wird.

Aus dem unteren Teil der Figur ist genauer die Art und Weise der Befestigung der Einbaukomponente 14-10 mittels Verschraubung von dessen Frontplatte 22-10 an den Einbaurahmenteilen 18-1, 18-2 ersichtlich (Schrauben 38 und Muttern 40). Insbesondere falls die vorrichtungseigenen RFID-Transponder 36 an dem Einbaurahmenteil 18-1 eine nennenswerte Dicke besitzen, so ist es wie dargestellt günstig, wenn die Vorderseite des linken Einbaurahmenteils 18-2 mit einem entsprechenden Abstandhalter 42 versehen ist (z. B. als durchgehende Leiste oder aus einzelnen Distanzstücken gebildet), um einen ansonsten "schiefen" Einbau der Frontplatte 22-10 und somit der Einbaukomponente 14-10 zu vermeiden. Das oder die Distanzstücke 42 müssen hierfür bei der dargestellten Konstruktion dieselbe Dicke wie die Transponder 36 besitzen.

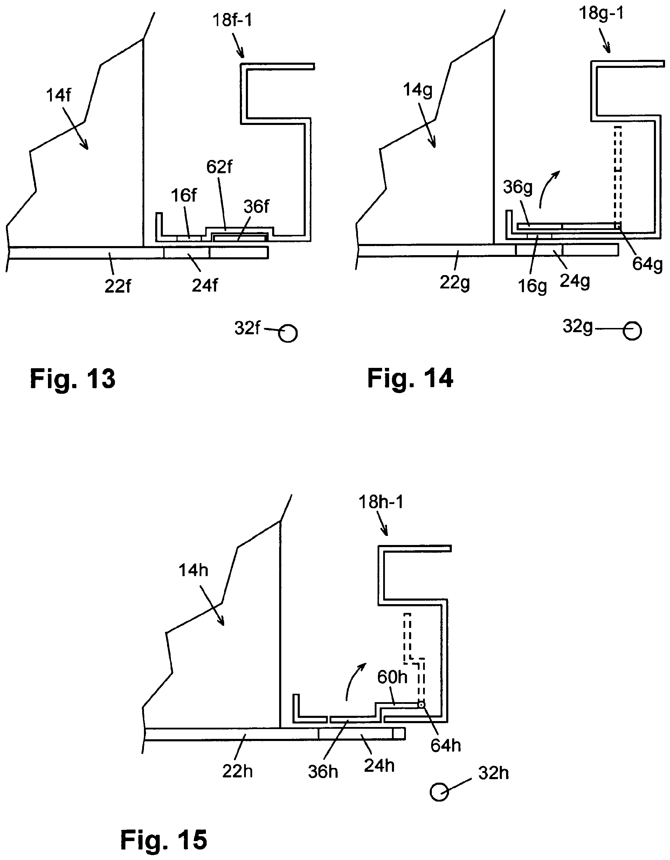

Um auch ohne die Anordnung eines solchen Abstandhalters eine ordnungsgemäße Einbauposition der Einbaukomponente zu gewährleisten, kommt z. B. eine geeignete Ausbuchtung des linken vorderen Einbaurahmenteils oder die weiter unten mit Bezug auf die Fig. 13 noch beschriebene Ausführungsvariante in Betracht.

Im vorstehend beschriebenen Beispiel kann die Einbauposition einer 1 HE-Einbaukomponente 14 exakt detektiert werden, weil für alle verschiedenen denkbaren Einbaupositionen jeweils unterscheidbare RFID-Erfassungsergebnisse resultieren. In entsprechender Weise kann bei einem Ausbau einer 1 HE-Einbaukomponente 14 ebenfalls eine exakte Information darüber gewonnen werden, welcher Abschnitt des Aufnahmeraumes 12 damit freigegeben wird. Diese Ausbildung des Einbaurasters und des Transponderrasters sind selbstverständlich nur beispielhaft zu verstehen. In der Praxis besonders interessant ist z. B. eine abgewandelte Gestaltung des Transponderrasters derart, dass damit eine exakte Erfassung (auf eine "Teilung" (hier z. B. 1/3 HE) des Einbaurasters genau) für alle Arten bzw. Bauhöhen von Einbaukomponenten aus einem betreffenden "Sortiment" an möglichen Einbaukomponenten ermöglicht ist. (Dies leistet z. B. das in Fig. 4 veranschaulichte Transponderraster mit "feinerer Teilung").

Bei dem vorstehend beschriebenen Beispiel sind die vorrichtungseigenen RFID-Transponder 36 wie beschrieben derart angeordnet, dass beim Einbau einer Komponente 14 (z. B. elektronisches Gerät oder Abdeckblende) jeweils ein Teil dieser Transponder überdeckt (abgeschirmt) wird. Eine geeignete Anordnung der Transponder 36 ist insbesondere dann leicht plan- bzw. realisierbar, wenn es sich beim betreffenden Sortiment an einbaubaren Komponenten 14 um Komponenten gemäß eines Standards handelt (z. B. für einen herkömmlichen "19-Zoll-Einbaurahmen"). Falls jedoch die Frontplatte einer Einbaukomponente als solche den oder die betreffenden Transponder 36 nicht überdecken würde, kann zusätzlich eine (hier als Abschirmblech dienende) seitliche Frontplattenerweiterung (mit gleicher Höhenausdehnung wie die Komponente selbst) mit angeschraubt werden, um die einwandfreie Transponder-Überdeckung zu gewährleisten.

Bei der nachfolgenden Beschreibung von weiteren Ausführungsbeispielen werden für gleichwirkende Komponenten die gleichen Bezugszahlen verwendet, jeweils ergänzt durch einen kleinen Buchstaben zur Unterscheidung der Ausführungsform. Dabei wird im Wesentlichen nur auf die Unterschiede zu dem bzw. den bereits beschriebenen Ausführungsbeispielen eingegangen und im Übrigen hiermit ausdrücklich auf die Beschreibung vorangegangener Ausführungsbeispiele verwiesen.

Die Fig. 4 und 5 veranschaulichen beispielhaft zwei Modifikationen eines durch die vorrichtungseigenen RFID-Transponder gebildeten Transponderrasters, die z. B. bei der Aufnahmevorrichtung 10 gemäß der Fig. 1 bis 3 einsetzbar sind.

So ist in Fig. 4 ein Transponderraster dargestellt, bei welchem für jedes Befestigungsloch 16a eines Einbaurahmenteils 18a-1 jeweils benachbart ein vorrichtungseigener RFID-Transponder 36a vorhanden ist.

Die Verwendung eines solchen feineren Transponderrasters gemäß Fig. 4 bei der Aufnahmevorrichtung 10 gemäß der Fig. 1 bis 3 ermöglicht besonders vorteilhaft eine exakte Detektion der Einbaupositionen (bzw. Ausbaupositionen) aller Arten von Einbaukomponenten aus dem betreffenden Einbaukomponenten-Sortiment (hier: z. B. 1-, 2-, 3- und 4HE-Einbaukomponenten). Dies deshalb, weil für alle verschiedenen denkbaren Einbaupositionen (bzw. Ausbaupositionen) jeweils unterscheidbare RFID-Erfassungsergebnisse resultieren. Im Rahmen einer Inventarisierung kann somit eine exakte Information darüber gewonnen werden, welche Einbaukomponenten sich wo genau im Aufnahmeraum befinden (auf 1/3 HE genau).

Fig. 5 veranschaulicht demgegenüber ein gröberes Transponderraster aus Transpondern 36b an einem Einbaurahmenteil 18b-1. Die Transponder 36b erstrecken sich in diesem Beispiel jeweils über die vertikale Ausdehnung von drei benachbarten Befestigungslöchern 16b. Ein damit im Rahmen eines RFID-Erfassungsverfahrens ermittelter bzw. aktualisierter Belegungsplan wäre entsprechend gröber.

Abweichend von den in Fig. 4 und 5 dargestellten Anordnungsstellen der Transponder 36a bzw. 36b könnten diese anstatt neben der Lochrasterreihe 16a bzw. 16b auch jeweils in den Zwischenräumen zwischen den einzelnen Befestigungslöchern 16a bzw. 16b angeordnet sein (wofür entsprechend kleindimensionierte Transponder von Vorteil sind).

Bei den bis hierher beschriebenen Beispielen von Transponderrastern wurde jeweils lediglich eines der beiden vorderen Einbaurahmenteile (rechtes vorderes Einbaurahmenteil 18-1, 18a-1 bzw. 18b-1) zur Anbringung bzw. Integration der vorrichtungseigenen RFID-Transponder verwendet.

Alternativ oder zusätzlich ist es jedoch z. B. auch möglich, vorrichtungseigene RFID-Transponder an dem anderen der beiden vorderen Einbaurahmenteile (und/oder einem anderen der etwaig vorhandenen Einbaurahmenteile) vorzusehen.

Auch ist es möglich, zur Anordnung der Transponder eine eigens hierfür vorgesehene Leiste zu verwenden und/oder eine ohnehin z. B. als mechanisches Stabilisierungsteil vorhandene Leiste zu verwenden.

Mehrere Transponderanordnungen (z. B. an mehreren Leisten, insbesondere parallel zueinander verlaufenden Leisten) können z. B. für eine Erfassungsredundanz vorteilhaft sein, wofür z. B. auf jeweils gleicher Position von zwei Leisten bzw. Einbaurahmenteilen (z. B. den beiden vorne links und rechts angeordneten Einbaurahmenteilen) jeweils ein Transponder angeordnet sein kann. Derartige Transponderanordnungen an den beiden vorderen Einbaurahmenteilen (oder anderen Leisten) können jedoch auch positionsmäßig (z. B. höhenmäßig) verschieden voneinander vorgesehen sein. Dies ist z. B. für eine Ausführung interessant, bei welcher das Transponderraster eine hohe Auflösung (Rasterung) besitzen soll, die (z. B. vertikale) Ausdehnung der verwendeten Transponder entlang eines einzigen Einbaurahmenteils bzw. Leiste dies jedoch nicht zulässt. In diesem Fall kann eine "verschachtelte Anordnung" dergestalt vorgesehen sein, dass an jedem der zur Transponderanordnung benutzten Leisten bzw. Einbaurahmenteile jeweils eine (z. B. vertikale) Reihe von (z. B. "dicht gepackten") Transpondern angeordnet ist, wobei die mehreren Transponderreihen jedoch zueinander versetzt sind. Bei Anordnung von zwei Transponderreihen können diese z. B. um einen halben (z. B. vertikalen) Transponderabstand zueinander versetzt sein.

Bei den oben beschriebenen Ausführungsbeispielen basiert die Erfassung der Position einer eingebauten oder gerade ausgebauten Einbaukomponente 14 darauf, dass die Kommunikationsstrecke zwischen den betreffenden vorrichtungseigenen RFID-Transpondern und einer für die Kommunikation mit diesen RFID-Transpondern vorgesehenen Antenne beim Einbau bzw. Ausbau zwangsläufig durch einen Abschnitt der betreffenden Frontplatte unterbrochen bzw. wieder freigegeben wird. Dieser Frontplattenbereich besitzt aufgrund seiner elektrisch leitfähigen (z. B. metallischen) Ausbildung eine (funktechnisch) abschirmende Wirkung. Die Kommunikation zwischen Transponder und Antenne wird bei in der Nähe eingebauter Einbaukomponente im beschriebenen Beispiel vollständig unterbunden.

Abweichend von diesem Wirkmechanismus könnten z. B. auch andere elektrisch leitfähige Bereiche der Einbaukomponenten (z. B. Teile eines metallischen Gehäuses) für diesen Abschirmeffekt genutzt werden, um die Positionserfassung zu ermöglichen.

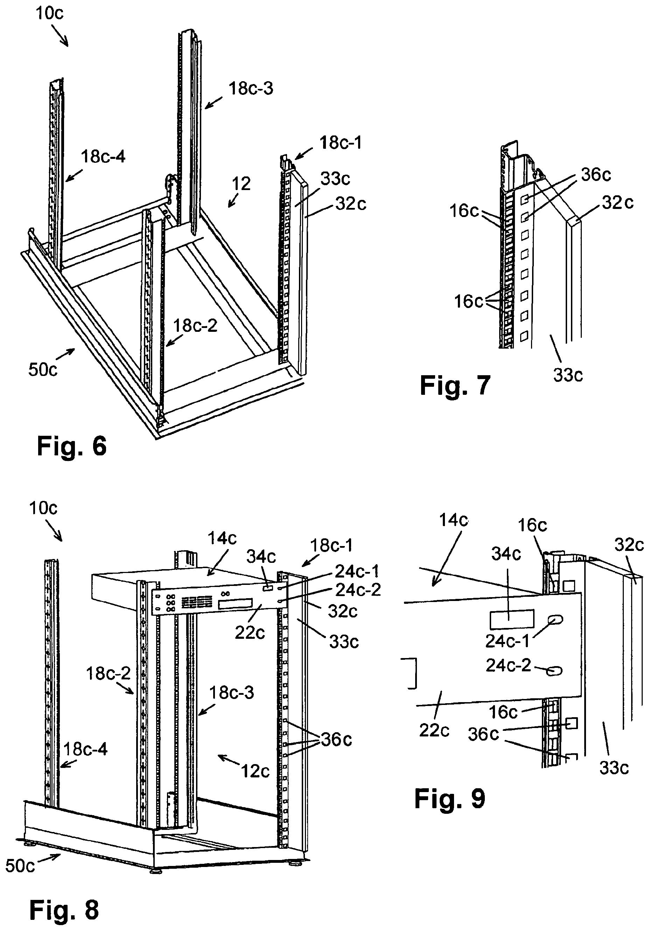

Die Fig. 6 bis 9 veranschaulichen ein weiteres Ausführungsbeispiel einer Aufnahmevorrichtung 10c, welche als ein so genanntes "Rack" ausgebildet ist.

Abgesehen von den bei dieser Vorrichtung 10 nicht vorhandenen äußeren Wandungen entspricht die Vorrichtung 10c in Aufbau und Funktion im Wesentlichen dem vorstehend mit Bezug auf die Fig. 1 bis 3 bereits beschriebenen Ausführungsbeispiel.

Aus den Darstellungen der Fig. 6 und 8 ist neben teilweise dargestellten, vertikal aufragenden Einbaurahmenteilen 18c-1 bis 18c-4 auch eine rechteckige Rahmenbasis 50c dargestellt, an welcher die unteren Enden der Einbaurahmenteile 18c festgelegt sind. Auch die (nicht dargestellten) oberen Enden der Einbaurahmenteile 18c sind durch einen entsprechenden Endrahmen in ihrer gegenseitigen Lage stabilisiert.

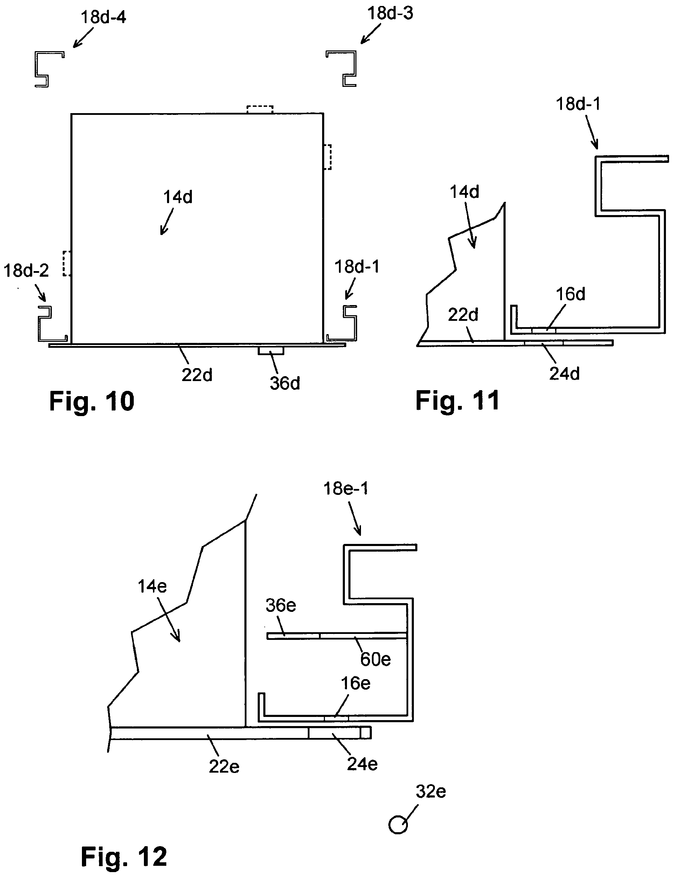

Fig. 10 zeigt beispielhaft anhand einer Einbaukomponente 14d eine Einbausituation, wie sie z. B. bei einer Aufnahmevorrichtung einer der oben bereits beschriebenen Arten (Schrank, Rack oder dergleichen) vorliegen kann.

Die Einbaukomponente 14d (wie auch ein gesamter für den Einbau derartiger Komponenten zur Verfügung stehender Aufnahmeraum 12d) ist wieder seitlich durch insgesamt vier Einbaurahmenteile 18d-1 bis 18d-4 begrenzt.

Falls wie dargestellt eine Befestigung der Einbaukomponente 14d lediglich an den vorderen Einbaurahmenteilen 18d-1, 18d-2 vorgesehen ist, so können zur mechanischen Unterstützung der Komponente 14d seitliche Trägerbleche (nicht dargestellt) eingebaut werden, auf denen die seitlichen unteren Bereiche der Komponente 14d aufliegen und welche jeweils horizontal zwischen den Einbaurahmenteilen 18d-1 und 18d-3 bzw. 18d-2 und 18d-4 verlaufen. Derartige Trägerbleche können z. B. wie die betreffende Komponente 14d an die Einbaurahmenteile angeschraubt werden.

In Fig. 10 gestrichelt eingezeichnet sind beispielhaft alternative Stellen zur Anbringung eines komponenteneigenen RFID-Transponders.

Für die Querschnittsgestaltung der Einbaurahmenteile 18d-1 bis 18d-4 kommen zahlreiche Möglichkeiten in Betracht. In Fig. 11 ist lediglich beispielhaft eine konkrete Querschnittsgestaltung gezeigt. Dieses Querschnittsbeispiel wird auch bei der nachfolgenden Beschreibung weiterer Ausführungsbeispiele zugrunde gelegt. Selbstverständlich sind jedoch bei allen Ausführungsbeispielen auch andere Querschnittsgestaltungen möglich.

Die Fig. 12 bis 19 veranschaulichen jeweils in einer der Fig. 11 entsprechenden Ansicht verschiedene Modifikationen, die an einer Aufnahmevorrichtung der bereits beschriebenen Art im Hinblick auf die Art und Weise der Anordnung von vorrichtungseigenen RFID-Transpondern vorgesehen sein können.

Wenn bei diesen nachfolgend beschriebenen Ausführungsbeispielen von einem bzw. dem vorrichtungseigenen RFID-Transponder die Rede ist, so bezieht sich dies auf den jeweils zeichnerisch dargestellten Transponder. Wie bei den bereits beschriebenen Aufnahmevorrichtungen sind tatsächlich jeweils eine Vielzahl derartiger Transponder auf einem vertikalen Transponderraster angeordnet. Da die einzelnen Transponder jedes Ausführungsbeispiels jedoch in gleicher Weise, lediglich vertikal zueinander versetzt angeordnet bzw. gelagert (z. B. dreh- oder schiebegelagert) sind, erübrigt sich deren Beschreibung.

Fig. 12 zeigt ein Ausführungsbeispiel, bei welchem ein Einbaurahmenteil 18e-1 nicht an seiner Vorderseite sondern dahinter mit einem vorrichtungseigenen RFID-Transponder 36e versehen ist.

Der Transponder 36e ist feststehend (stationär) über einen Halteabschnitt 60e am Einbaurahmenteil 18e-1 angebunden. Der Abschnitt 60e kann einen integralen Bestandteil des als Profil ausgebildeten Einbaurahmenteils 18e-1 bilden, oder als separates Bauteil ausgebildet sein.

Wenn wie dargestellt eine Einbaukomponente 14e in der Nähe des Transponders 36e positioniert wird, so bewirkt die Frontplatte 22e der Einbaukomponente 14e wieder eine Abschirmung des Transponders 36e von einer zugeordneten RFID-Antenne 32e. Nach einem Ausbau der Komponente 14e kann eine Kommunikation zwischen der Antenne 32e und dem Transponder 36e "durch das Befestigungsloch 16e hindurch" erfolgen. Wie dargestellt besteht bei ausgebauter Komponente 14e eine funktechnische "Sichtverbindung" zwischen Antenne 32e und Transponder 36e.

Anzumerken ist, dass auch in dem Fall, in welchem das Befestigungsloch 16e mit einem Befestigungsloch 24e an der Frontplatte 22e fluchtet, diese Abschirmung im eingebauten Zustand der Komponente 14e erfolgt, nämlich durch die an dieser Stelle vorhandene Verschraubung (mittels abschirmender Schraube und Mutter).

Der Transponder 36e ist im dargestellten Ausführungsbeispiel auf gleicher Höhe wie das dargestellte Befestigungsloch 16e angeordnet, jedoch in einem horizontalen Abstand, welcher eine problemlose Verschraubung der Frontplatte 22e gestattet.

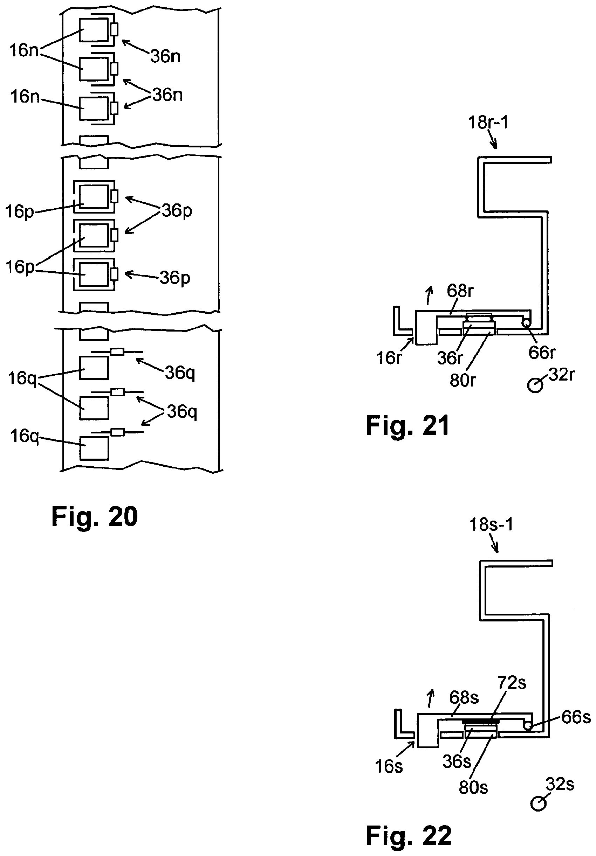

Fig. 13 zeigt ein Ausführungsbeispiel ähnlich den oben bereits mit Bezug auf die Fig. 1 bis 3 und 6 bis 9 beschriebenen Ausführungsbeispielen. Insbesondere ist bei dem Beispiel gemäß Fig. 13 ein Transponder 36f wieder an der Vorderseite eines Einbaurahmenteils 18f-1 angeordnet. Dies allerdings in einer Ausnehmung 62f, deren Tiefe etwa der Dicke des Transponders 36f entspricht, so dass durch den Transponder 36f eine flächige Anlage einer Frontplatte 22f einer Einbaukomponente 14f an der Vorderseite des Einbaurahmenteils 18f-1 nicht behindert wird. Die Ausnehmung 62f kann z. B. wie dargestellt durch eine entsprechende Formgestaltung des Einbaurahmenprofils 18f-1 realisiert sein. Alternativ könnte das Profil 18f-1 z. B. eine (von Vorder- zu Rückseite) durchgehende Ausnehmung (Durchbruch) aufweisen, in welche die einzelnen Transponder 36f oder eine diese tragende Leiste (z. B. Kunststoffstreifen) eingesetzt ist (ähnlich der Ausnehmung wie für die Beispiele gemäß der Fig. 21 und 22 beschrieben).

Bei den bis hierher beschriebenen Ausführungsbeispielen sind die vorrichtungseigenen RFID-Transponder stationär innerhalb der Aufnahmevorrichtung angeordnet. Nachfolgend werden mit Bezug auf die Fig. 14 bis 17 Ausführungsbeispiele mit verlagerbaren Transpondern erläutert. Diesen Ausführungsbeispielen liegt die Idee zugrunde, bei einem Einbau oder Ausbau einer Einbaukomponente die Qualität der Kommunikationsstrecke zwischen den jeweiligen vorrichtungseigenen RFID-Transponder und einer für die Kommunikation mit diesem Transponder vorgesehenen Antenne durch eine zwangsgesteuerte (alternativ: manuell bewirkte) Lageveränderung des jeweiligen vorrichtungseigenen Transponders zu verändern.

Fig. 14 zeigt ein Ausführungsbeispiel eines Einbaurahmenteils 18g-1 mit einem RFID-Transponder 36g, der über einen verschwenkbaren Halteabschnitt 60g an dem Einbaurahmenteil 18g-1 angebunden ist.

Falls in der Nähe des Transponders 36g keine Einbaukomponente vorhanden ist, so besteht eine (funktechnische) "Sichtverbindung" zwischen Transponder 36g und einer zugeordneten RFID-Antenne 32g. Wenn jedoch an dieser Stelle eine Einbaukomponente eingebaut wird, so erfolgt wieder eine Abschirmung durch die Frontplatte, oder eine zwangsgesteuerte Verschwenkung des Transponders 36g um eine vertikale Schwenkachse 64g, bei welcher der Transponder 36g in die gestrichelt eingezeichnete Lage bewegt wird, in welcher die RFID-Kommunikation mit der Antenne 32g unterbunden ist. Dies deshalb, weil der Transponder 36g in der gestrichelt eingezeichneten Lage sich in einem von der Antenne kaum oder gar nicht "ausgeleuchteten" Raumbereich befindet, welcher durch das z. B. metallisch ausgebildete Einbaurahmenteil 18g-1 abgeschirmt wird.

Eine einfache Möglichkeit für die zwangsgesteuerte Lageveränderung des Transponders 36g besteht z. B. darin, dass diese durch ein Einsetzen einer Schraube in das zugehörige Befestigungsloch 16g bewirkt wird (der Transponder 36g wird durch die Schraube bzw. eine gegebenenfalls hinter dem Befestigungsloch 16g eingebrachte Schraubenmutter verdrängt). Diese Verschwenkung erfolgt entgegen der rückstellenden Kraft einer (nicht dargestellten) Feder, welche den verschwenkten Transponder 36g nach einem Ausbau der betreffenden Einbaukomponente wieder in seine Ausgangslage zurückverschwenkt.

Alternativ oder zusätzlich zum Unterbinden der RFID-Kommunikation beim Einsetzen der Befestigungsschraube kann bei diesem Ausführungsbeispiel auch vorteilhaft der oben bereits beschriebene Abschirmeffekt durch eine elektrisch leitfähige Frontplatte der betreffenden Einbaukomponente genutzt werden.

Fig. 15 zeigt eine gegenüber Fig. 14 geringfügig modifizierte Ausführungsform, bei welcher ein zur Schwenklagerung vorgesehener Halteabschnitt 60h an seinem transponderseitigen Ende derart gekröpft ist, dass ein an diesem Ende festgelegter Transponder 36h mit seiner Vorderseite nach vorne hin etwas aus einem zugeordnetem Befestigungsloch 16h eines Einbaurahmenteils 18h-1 herausragt. Damit kann z. B. die Qualität der RFID-Kommunikation bei unverschwenktem Transponder 36h verbessert werden.

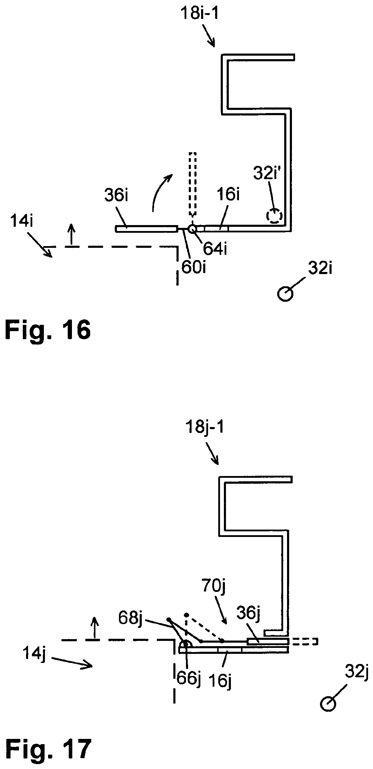

Fig. 16 zeigt ein Ausführungsbeispiel, bei welchem ein Transponder 36i wieder über einen Halteabschnitt 60i um eine vertikale Schwenkachse 64i zwangsweise verschwenkbar ist.

Im Unterschied zu den Beispielen gemäß der Fig. 14 und 15 befindet sich der unverschwenkte Transponder 36i jedoch in Querrichtung betrachtet nicht im Bereich eines zugeordneten Befestigungsloches 16i, sondern näher an der Vorrichtungsmitte hin positioniert (zwischen den vorderen Einbaurahmenteilen), so dass dessen zwangsweise Verlagerung (hier: Verschwenkung) durch eine Verdrängung des Transponders 36i durch ein Gehäuse einer einzubauenden Einbaukomponente (ebenfalls gestrichelt eingezeichnet) realisiert ist.

In konstruktiv besonders einfacher Weise kann der Halteabschnitt 60i z. B. als ein so genanntes Filmscharnier ausgebildet sein, etwa als ein dauerelastischer Kunststoffstreifen, welcher beim Einbau einer Einbaukomponente reversibel umgebogen wird und beim Ausbau der Komponente somit wieder in seine Ausgangsstellung zurückkehrt.

Hinsichtlich der mit Bezug auf die Fig. 14 bis 16 beschriebenen Beispiele ist anzumerken, dass deren Realisierung selbst dann möglich ist, wenn das betreffende Einbaurahmenteil keine elektromagnetisch abschirmende Wirkung besitzt und z. B. aus nicht-abschirmendem Kunststoff gefertigt ist. In diesem Fall kann nämlich vorgesehen sein, dass die RIFD-Kommunikation durch die in diesen Beispielen erfolgende Orientierungsveränderung des vorrichtungseigenen RFID-Transponders verändert wird. Hierfür kommt beispielsweise eine geeignet winkelabhängige Sende- und/oder Empfangscharakteristik des verwendeten RFID-Transponders oder ein Polarisationseffekt in Betracht.

In Fig. 16 gestrichelt eingezeichnet ist eine alternative Anordnungsstelle einer RFID-Antenne 32i', welche den Transponder 36i nur dann erfasst, wenn die Einbaukomponente eingebaut ist (und nicht erfasst, wenn an der betreffenden Stelle keine Einbaukomponente eingebaut ist). Entsprechende alternative (oder zusätzliche) Antennenanordnungen (hinter einem Einbaurahmenteil) ergeben sich z. B. auch bei den Beispielen gemäß der Fig. 14 und 15.

Fig. 17 zeigt ein Ausführungsbeispiel, bei welchem ähnlich dem Beispiel gemäß Fig. 16 durch ein (gestrichelt eingezeichnetes) Gehäuse einer Einbaukomponente ein z. B. federnd um eine Schwenkachse 66j angelenkter Arm 68j zwangsweise verschwenkt wird. In diesem Fall wird über eine nur schematisch eingezeichnete mechanische Wirkverbindung 70j ein verschiebbar an einem Einbaurahmenteil 18j-1 gelagerter Transponder 36j durch eine seitlich äußere Öffnung des Einbaurahmenteils 18j-1 herausgeschoben. Die Wirkverbindung kann im dargestellten Ausführungsbeispiel z. B. eine Schubstange zwischen dem Arm 68j und dem Transponder 36j bzw. einem Träger dieses Transponders umfassen.

Bei den vorstehend beschriebenen Ausführungsbeispielen mit einem beim Einbau bzw. Ausbau einer Einbaukomponente verlagerbaren RFID-Transponder könnte alternativ auch jeweils eine Bedieneinrichtung bzw. ein Bedienelement vorgesehen sein, welches ein Benutzer manuell betätigen kann, wenn er eine Einbaukomponente einbaut oder ausbaut.

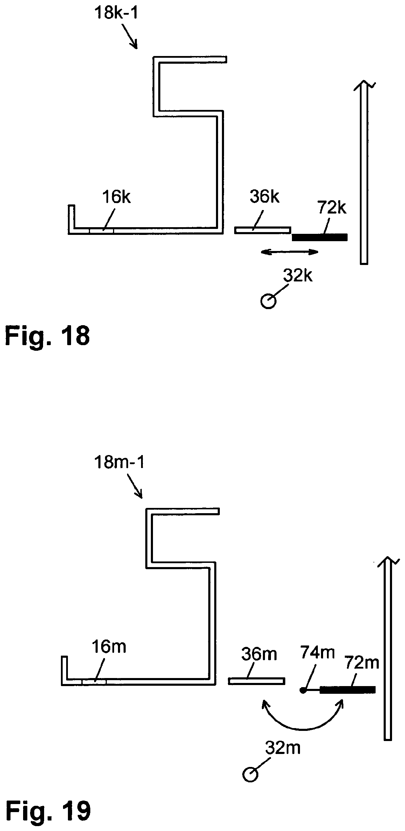

Bei den nachfolgend mit Bezug auf die Fig. 18 und 19 beschriebenen Ausführungsbeispielen ist eine solche manuelle Bedienung zwecks Beeinflussung der RFID-Kommunikation vorgesehen. Bei diesen Ausführungsbeispielen könnte alternativ zur manuellen Bedienung wiederum eine zwangsgesteuerte bzw. zwangsläufige Verlagerung eines Bauteils vorgesehen sein kann.

Fig. 18 zeigt ein Ausführungsbeispiel, bei welchem ein vorrichtungseigener RFID-Transponder 36k (z. B. separat von einem Einbaurahmenteil) 18k-1 stationär in der betreffenden Aufnahmevorrichtung gehalten ist. Der Transponder 36k kann hierfür z. B. über einen Halteabschnitt mit einem anderen stationären Teil der Vorrichtung verbunden sein (bei einem Schrank z. B. mit einer benachbarten Seitenwand verbunden).

Als manuell zu betätigendes Bedienelement ist ein z. B. als Schieber ausgebildetes Abschirmblech 72k vorgesehen, welches in nicht näher dargestellter Weise in Richtung des Doppelpfeils in der Figur verschiebbar ist, so dass ein Benutzer durch entsprechende Verschiebung des Abschirmbleches 72k die Kommunikation zwischen dem Transponder 36k und einer zugeordneten RFID-Antenne 32k wahlweise unterbinden oder freigeben kann. Abweichend vom dargestellten Ausführungsbeispiel könnte der Transponder 36k hierfür auch direkt an dem Einbaurahmenteil 18k-1 angeordnet sein, z. B. wie bei dem Beispiel gemäß Fig. 13 dargestellt.

Fig. 19 zeigt ein gegenüber dem Beispiel von Fig. 18 geringfügig modifiziertes Ausführungsbeispiel. Ein Transponder 36m ist wieder stationär im Bereich eines Einbaurahmenteils 18m-1 angeordnet und kann durch eine Verlagerung eines Abschirmbleches 72m wahlweise abgeschirmt oder freigegeben werden. Das Abschirmblech 72m ist hierfür um eine vertikale Schwenkachse 74m verschwenkbar (vgl. Doppelpfeil).

Fig. 20 veranschaulicht beispielhaft weitere Möglichkeiten zur Anordnung von vorrichtungseigenen RFID-Transpondern 36n, 36p bzw. 36q entlang eines Einbaurahmenteils (z. B. vertikale Lochleiste) der Aufnahmevorrichtung.

Die Transponder können z. B. in an sich bekannter Weise als aufklebbare Transponderstreifen mit einem integrierten Schaltkreis ("Transponder-Chip") und davon abstehenden Antennenabschnitten (z. B. dipolartig) ausgebildet sein. In Fig. 20 sind die Transponder 36n, 36p bzw. 36q jeweils durch solche Schaltkreise samt zugehörigen Antennenabschnitten symbolisiert.

Zur Veränderung der Transponderwirkung in Abhängigkeit von einem Vorhandensein oder Nicht-Vorhandensein einer Einbaukomponente in der Nähe des jeweiligen Transponders kann im Falle der dargestellten Transponder 36n und 36p ein Kurzschließen jeweiliger Antennenabschnitte durch direkte Kontaktierung dieser Antennenabschnitte durch eine elektrisch leitfähige Frontplatte der oben bereits beschriebenen Art erfolgen (Die Transponder und/oder die Frontplatte können hierfür z. B. mit Federkontakten versehen sein, um eine zuverlässige Kontaktierung zu gewährleisten). In diesem Fall kann die oben bereits beschriebene Abschirmwirkung einer solchen Frontplatte also von einer Antennenwirkungsbeeinflussung (durch Kurzschluss von Antennenabschnitten) begleitet sein.

Bei dem Transponder 36q kann die Veränderung der Transponderwirkung auf einer Abschirmung und/oder elektrischen Kontaktierung eines von zwei Antennenabschnitten des Transponders 36q beruhen.

Fig. 21 zeigt ein Ausführungsbeispiel, bei welchem ein vorrichtungseigener RFID-Transponder 36r auf der Rückseite eines "funktechnisch durchlässigen" (nicht abschirmenden) Streifens 80r (z. B. aus Kunststoff) angeordnet ist, welcher in eine geeignete Ausnehmung eines z. B. metallischen Einbaurahmenteils 18r-1 eingesetzt ist (z. B. angeschraubt oder verklebt). Zur Kommunikation mit dem Transponder 36r ist die in Fig. 21 symbolisierte RFID-Antenne 32r vorgesehen.

Wenn in der Nähe des Transponders 36r eine Einbaukomponente (nicht dargestellt) eingebaut wird, so erfolgt eine zwangsläufige Verschwenkung eines Arms 68r (siehe Pfeil), der entgegen einer Federkraft um eine Schwenkachse 66r angelenkt ist. Durch diese Verschwenkung gelangen zwei elektrische Kontakte auf der dem Transponder 36r zugewandten Seite des Arms 68r aus dem elektrischen Kontakt mit korrespondierend an der Rückseite des Transponders 36r angeordneten elektrischen Kontakten. Dadurch wird im dargestellten Beispiel ein Kurzschluss der beiden elektrischen Kontakte des Transponders 36r, welcher in der Situation gemäß Fig. 21 vorliegt, aufgehoben. Somit stellt der zwangsläufig verschwenkbare Arm 68r mit den daran angeordneten Kurzschlusskontakten ein Beeinflussungsmittel zur Signalisierung des Vorhandenseins bzw. Nicht-Vorhandenseins einer Einbaukomponente an den Transponder 36r dar. Der Transponder 36r ist so ausgebildet, dass dessen Transponderwirkung (z. B. übertragene Daten) in Abhängigkeit von der genannten Signalisierung verändert wird.

Fig. 22 zeigt ein gegenüber dem Beispiel von Fig. 21 geringfügig modifiziertes Ausführungsbeispiel. Ein Transponder 36s ist wieder an der Rückseite eines nicht abschirmenden Streifens 80s angeordnet, wobei dessen Transponderwirkung wieder durch eine Verschwenkung eines Arms 68s um eine Schwenkachse 66s veränderbar ist.

Im Unterschied zum Beispiel gemäß Fig. 21 ist der Arm 68s jedoch nicht mit elektrischen Kontakten zur Zusammenwirkung mit entsprechenden Gegenkontakten des Transponders versehen, sondern mit einem elektrisch leitfähigen Blech 72s, welches je nach Verschwenkungsstellung des Arms 68s entweder sehr nahe an der Transponderrückseite oder etwas davon entfernt angeordnet ist.

Bei diesem Beispiel erfolgt durch die zwangläufige Verlagerung des Bleches 72s eine Beeinflussung der Wirkung der Antenne des RFID-Transponders 36s. Diese Veränderung der Antennenwirkung und somit Transponderwirkung kann derart vorgesehen sein, dass in einem Fall die Kommunikation mit der RFID-Antenne 32s ermöglicht und in dem anderen unterbunden ist.

Die bei den Beispielen gemäß Fig. 21 und 22 vorgesehenen Streifen 80r und 80s können insbesondere als in Richtung des entsprechenden Einbaurahmenteils 18r-1 bzw. 18s-1 mehr oder weniger durchgehend verlaufende Streifen sein, die zum Zeitpunkt ihres Einbaus bzw. Anbaus an das Einbaurahmenteil bereits mit einer entsprechenden Vielzahl von Transponders 36r bzw. 36s samt zugeordneten "Beeinflussungsmitteln" versehen sind ("Transponderleiste").

## Patentansprüche

1. Aufnahmevorrichtung, insbesondere Schrank oder Rack, mit einem Aufnahmeraum (12) zur Aufnahme von mit RFID-Transpondern (34) versehenen Einbaukomponenten (14), mit einer Erfassungseinrichtung zur Erfassung von aufgenommenen Einbaukomponenten (14), die mit einer Auswerteeinrichtung (30) verbunden oder verbindbar ist und wenigstens eine RFID-Antenne (32) zur Kommunikation mit den komponenteneigenen RFID-Transpondern (34) aufweist,
und mit einer Mehrzahl von entlang des Aufnahmeraumes (12) verteilt angeordneten vorrichtungseigenen RFID-Transpondern (36), wobei die mit der zur Kommunikation mit den komponenteneigenen RFID-Transpondern (34) vorgesehene RFID-Antenne (32) oder wenigstens eine weitere RFID-Antenne zur Kommunikation mit den vorrichtungseigenen RFID-Transpondern (36) nutzbar bzw. vorgesehen ist,
und wobei durch den Einbau oder Ausbau einer Einbaukomponente (14)
die Lage einen Abschirmeffekt bewirkender elektrisch leitfähiger metallischer Gehäusebereiche der Einbaukomponente (22) und/oder eines metallischen Abschirmblechs (72k) der Aufnahmevorrichtung verändert wird
und/oder
der Abstand zwischen vorrichtungseigenem RFID-Transponder (36) und der zur Kommunikation mit den vorrichtungseigenen Transpondern vorgesehenen Antenne verändert wird
und/oder
die Orientierung eines vorrichtungseigenen RFID-Transponders (36) zu der zur Kommunikation mit den vorrichtungseigenen Transpondern vorgesehenen RFID-Antenne (32) so verändert wird, dass der vorrichtungseigene RFID-Transponder in einen abgeschirmten Bereich hinein bzw. aus diesem heraus bewegt wird oder eine Veränderung der Signalstärke aufgrund von richtungs- oder polarisationsabhängigen Sende- und Empfangseigenschaften bewirkt wird,
so dass die Kommunikation zwischen dem vorrichtungseigenen Transponder (36) und der Antenne (32) durch das Vorhandensein der Einbaukomponente (14) verschlechtert bzw. ganz unterbunden ist oder erst ermöglicht bzw. nennenswert verbessert wird, wodurch eine Erfassung der Einbaupositionen innerhalb des Aufnahmeraums ermöglicht wird.

2. Aufnahmevorrichtung nach Anspruch 1, wobei mögliche Einbaupositionen der Einbaukomponenten (14) im Aufnahmeraum (12) durch ein Einbauraster der Aufnahmevorrichtung (10) vorgegeben sind, insbesondere durch ein Einbauraster, welches durch die Positionen einer entlang eines langgestreckten Einbaurahmenteils (18) ausgebildete Reihe von Befestigungsmitteln (16) definiert ist.

3. Aufnahmevorrichtung nach einem der vorangehenden Ansprüche, wobei die vorrichtungseigenen RFID-Transponder (36) auf einem entlang des Aufnahmeraumes (12) verlaufenden Transponderraster angeordnet sind, insbesondere einem Transponderraster, welches korrespondierend zu einem Einbauraster der Aufnahmevorrichtung (10) ausgebildet ist.

4. Aufnahmevorrichtung nach einem der vorangehenden Ansprüche, wobei die wenigstens eine zur Kommunikation mit den komponenteneigenen RFID-Transpondern (34) vorgesehene RFID-Antenne (32) auch zur Kommunikation mit den vorrichtungseigenen RFID-Transpondern (36) nutzbar ist.

5. Aufnahmevorrichtung nach einem der vorangehenden Ansprüche, wobei die Erfassungseinrichtung zur Kommunikation mit den vorrichtungseigenen RFID-Transpondern (36) wenigstens eine weitere RFID-Antenne aufweist.

6. Aufnahmevorrichtung nach einem der vorangehenden Ansprüche, wobei durch einen Benutzer manuell bedienbare Mittel zur Bewirkung einer Veränderung der Transponderwirkung der vorrichtungseigenen RFID-Transponder (36) vorgesehen sind.

7. RFID-Erfassungsverfahren, durchgeführt mittels einer Aufnahmevorrichtung (10) nach einem der Ansprüche 1 bis 6.

## Claims

1. Accommodation device, particularly a cabinet or rack, having an accommodation space (12) for accommodating installed components (14) equipped with RFID transponders (34), having a detection device for detecting accommodated installed components (14) which is or can be connected to an evaluation device (30), and at least one RFID antenna (32) for communicating with the components' own RFID transponders (34),
and having a plurality of the device's own RFID transponders (36) distributed along the accommodation space (12), wherein the RFID antenna (32) can be used and is provided for communicating with the components' own RFID transponders (34) or at least one further RFID antenna can be used and is provided for communicating with the device's own RFID transponders (36),
and wherein the installation or removal of an installed component (14)
has the effect of changing the position of electrically conductive metal housing regions of the installed component (22) that have a shielding effect and/or of a metal shielding panel (72k) of the accommodation device
and/or
changing the distance between the device's own RFID transponder (36) and the antenna provided for communication with the device's own transponders,
and/or
changing the orientation of one of the device's own transponders (36) with respect to the RFID antenna (32) for communicating with the device's own transponders in such manner that the device's own transponder is moved into or out of a shielded region or the signal strength thereof is changed as a result of directional or polarisation-dependent transmitting and receiving properties,
so that the communication between the device's own transponder (36) and the antenna (32) is degraded or entirely prevented or enabled or significantly improved by the presence of the installed component (14), thereby enabling detection of the installation positions within the accommodation space.

2. Accommodation device according to claim 1, wherein possible installation positions of the installed components (14) in the accommodation space (12) are defined by an installation grid of the accommodation device (10), particularly by an installation grid which is defined by the positions of a series of fastening means (16) conformed along an elongated installed frame member (18).

3. Accommodation device according to any one of the preceding claims, wherein the device's own RFID transponders (36) are arranged on a transponder grid that extends along the accommodation space (12), particularly a transponder grid that is conformed correspondingly to an installation grid of the accommodation device (10).

4. Accommodation device according to any one of the preceding claims, wherein the at least one components' own RFID antenna (32) provided for communicating with the components' own RFID transponders (34) can also be used to communicate with the device's own RFID transponders (36).

5. Accommodation device according to any one of the preceding claims, wherein the detection device includes at least one further RFID antenna for communicating with the device's own RFID transponders (36).

6. Accommodation device according to any one of the preceding claims, wherein means that are manually operable by an operator are provided for causing a change in the transponder effect of the device's own RFID transponders (36).

7. RFID detection method performed by means of an accommodation device (10) according to any one of claims 1 to 6.

## Revendications

1. Dispositif de réception, notamment armoire ou rack, avec un espace réceptacle (12) destiné à recevoir des composants (14) munis de transpondeurs RFID (34), avec un système de détection pour détecter des composants (14) réceptionnés, lequel est connecté ou peut se connecter sur un système d'évaluation (30) et comporte au moins une antenne RFID (32) pour communiquer avec les transpondeurs RFID (34) propres aux composants,
et avec une pluralité de transpondeurs RFID (36) propres au dispositif, placés en étant distribués le long de l'espace réceptacle (12) qui sont utilisables ou prévus pour communiquer avec l'antenne RFID (32) prévue pour communiquer avec les transpondeurs RFID (34) propres aux composants ou au moins avec une antenne RFID supplémentaire pour communiquer avec les transpondeurs RFID (36) propres au dispositif,
et le montage ou le démontage d'un composant (14) modifiant la position de zones conductrices d'électricité provoquant un effet de blindage du boîtier métallique du composant (22) et/ou d'une tôle de blindage (72k) du dispositif de réception
et/ou
modifiant l'écart entre des transpondeurs RFID (36) propres au dispositif et l'antenne prévue pour communiquer avec les transpondeurs propres au dispositif
et/ou
modifiant l'orientation d'un transpondeur RFID (36) propre au dispositif par rapport à l'antenne RFID (32) prévue pour communiquer avec les transpondeurs propres au dispositif de telle sorte que le transpondeur RFID propre au dispositif soit déplacé à l'intérieur d'une zone blindée ou hors de celle-ci ou que soit provoquée une modification de l'intensité de signaux due à des propriétés d'émission et de réception dépendant de la direction ou de la polarisation,
de sorte que la communication entre le transpondeur (36) propre au dispositif et l'antenne (32) soit dégradée, voire totalement supprimée par la présence des composants (14) ou soit enfin permise, voire notablement améliorée, suite à quoi une détection de la position de montage à l'intérieur de l'espace réceptacle est possible.

2. Dispositif de réception selon la revendication 1, wobei môgliche Einbaupositionen der composants (14) im espace réceptacle (12) durch ein Einbauraster der Dispositif de réception (10) vorgegeben sind, insbesondere durch ein Einbauraster, welches durch die Positionen einer entiang eines Ianggestreckten Einbaurahmenteils (18) ausgebildete Reihe von Befestigungsmitteln (16) definiert ist.

3. Dispositif de réception selon l'une quelconque des revendications précédentes, les transpondeurs RFID (36) propres au dispositif étant placés sur une trame de transpondeurs, s'étendant le long de l'espace réceptacle (12), notamment d'une trame de transpondeurs laquelle est conçue en correspondance avec le dispositif de réception (10).

4. Dispositif de réception selon l'une quelconque des revendications précédentes, l'au moins une antenne RFID (32) prévue pour communiquer avec les transpondeurs RFID (34) propres aux composants étant utilisable également pour la communication avec les transpondeurs RFID (36) propres au dispositif.

5. Dispositif de réception selon l'une quelconque des revendications précédentes, pour la communication avec les transpondeurs RFID (36) propres au dispositif, le système de détection comportant au moins une antenne RFID supplémentaire.

6. Dispositif de réception selon l'une quelconque des revendications précédentes, des moyens directement actionnables par un utilisateur étant prévus pour provoquer une modification de l'effet des transpondeurs RFID (36) propres au dispositif.

7. Procédé de détection RFID, réalisé au moyen d'un dispositif de réception (10) selon l'une quelconque des revendications 1 à 6.
